# EUROPÄISCHE PATENTSCHRIFT

(11) **EP 3 620 806 B1**
(45) Veröffentlichungstag und Bekanntmachung des Hinweises auf die Patenterteilung: **19.07.2023**
(21) Anmeldenummer: 18192937.3
(22) Anmeldetag: 06.09.2018
(51) Int. Cl.: G01R 33/025, G01R 33/3875

(54) **SYSTEM ZUR MAGNETFELDKOMPENSATION**
SYSTEM FOR COMPENSATING FOR MAGNETIC FIELDS
SYSTÈME DE COMPENSATION DE CHAMP MAGNÉTIQUE

(43) Veröffentlichungstag der Anmeldung: 11.03.2020
(73) Patentinhaber: Integrated Dynamics Engineering GmbH, 65479 Raunheim (DE)
(72) Erfinder: BIRKNER, Andreas, 07743 Jena (DE); KAPPEL, Roland, 65195 Wiesbaden (DE)
(74) Vertreter: Blumbach · Zinngrebe Patentanwälte PartG mbB

(56) Entgegenhaltungen:
- EP-A1- 2 910 965
- JP-A- 2002 232 182
- US-A- 4 949 043
- US-A1- 2010 308 811
- H. Merkle et al.: "Chapter 2: Hardware Requirements for In Vivo Nuclear Magnetic Resonance Studies of Neural Metabolism", Neural Metabolism In Vivo (In-Young Choi, Rolf Gruetter), 14. März 2012 (2012-03-14), Seite 36, XP002790163, Springer Science & Business Media ISBN: 1461417872 Gefunden im Internet: URL:https://books.google.de/books?id=aGc5E C66OcYC&lpg=PA36&ots=8D8F7HMtTD&dq=in-youn g%20choi%20rolf%20gruetter%20eural%20metab olism%20in%20vivo%20shim%20coil%20bus&hl=d e&pg=PA36#v=onepage&q=in-young%20choi%20ro lf%20gruetter%20eural%20metabolism%20in%20 vivo%20shim%20coil%20bus&f=false [gefunden am 2019-03-29]
- Shaoxiong Wu: "Unity 600 AP BUS Interconnection", Emory University - NMR RESEARCH CENTER , 13. Januar 2005 (2005-01-13), XP002790164, Gefunden im Internet: URL:http://www.emory.edu/NMR/web_swu/Hardw are/unity.htm [gefunden am 2019-03-29]

## Beschreibung

### Gebiet der Erfindung

Die Erfindung betrifft ein System zur Magnetfeldkompensation sowie dessen Verwendung. Insbesondere betrifft die Erfindung ein System zur Magnetfeldkompensation, mit welchem Geräte zur Prozessierung von Halbleiterbauelementen magnetisch aktiv geschirmt sind.

### Hintergrund der Erfindung

In der Industrie, Forschung sowie auf anderen Gebieten, wie beispielsweise in der Medizintechnik, werden Maschinen eingesetzt, welche empfindlich gegenüber von außen einwirkenden elektromagnetischen Feldern sind. Dies sind z.B. Elektronenstrahl-Inspektionssysteme, welche in der Halbleiterindustrie für die Inspektion von Wafern verwendet werden.

Von außen einwirkende Magnetfelder beeinflussen den für die Inspektion verwendeten Elektronenstrahl. Es ist bekannt, derartige Geräte entsprechend des Erdmagnetfeldes auszurichten. Neben dem Erdmagnetfeld kann es aber zu einer Vielzahl weiterer überlagernder Felder kommen, so dass sich das an einem bestimmten Ort vorhandene Magnetfeld laufend ändern kann.

Um die durch Magnetfeldänderungen verursachten Störungen zu minimieren, sind zum einen passive Schirmungen, beispielsweise aus einem Material mit hoher magnetischer Permeabilität bekannt.

Weiter bekannt sind auch Systeme zur aktiven Magnetfeldkompensation.

Dabei wird mittels eines Sensors das Magnetfeld möglichst nah am Ort des zu schirmenden Gerätes in zumindest einer Raumrichtung gemessen. Über einen Controller werden Spulen in der Art und Weise angesteuert, dass diese dem externen Magnetfeld entgegenwirken und dieses zumindest teilweise kompensieren.

Es ist insbesondere bekannt, hierfür Helmholtz-Spulen zu verwenden, welche auf einem Ständer frei im Raum aufgestellt werden.

Eine derartige aktive Magnetfeldkompensation ist beispielsweise in der Patentschrift EP 2 259 081 B1 (Integrated Dynamics Engineering GmbH) beschrieben.

Die Druckschrift EP 2 910 965 A1 beschreibt eine Schaltungsanordnung für ein MRI-Gerät mit mehreren Spulen. Die Druckschrift In-Young Choi, Rolf Gruetter: "eural Metabolism In Vivo", Springer Science & Business Media, 14. März 2012, zeigt eine weitere Schaltungsanordnung für ein MRI-Gerät. Die Druckschrift "Unity600 AP BUS Interconnection", gefunden im Internet, 13. Januar 2005, zeigt eine nochmals weitere Schaltungsanordnung. Die Druckschrift JP 2002 232 182 A beschreibt eine käfigartige Anordnung von Spulen, mit welcher eine Kammer oder ein Raum mit aktiver Magnetfeldabschirmung zur Verfügung gestellt werden soll.

Aus der Praxis bekannte Systeme zur aktiven Magnetfeldkompensation sind oft umständlich aufzustellen. Insbesondere müssen Kabel durch den Raum verlegt werden. Das System muss im Anschluss kalibriert werden und die aufgestellten Spulen können störende Hindernisse im Raum bilden.

### Aufgabe der Erfindung

Der Erfindung liegt demgegenüber die Aufgabe zugrunde, ein System zur Magnetfeldkompensation bereitzustellen, welches komfortabel und/oder flexibel aufbaubar ist und bei welchem die genannten Nachteile des Standes der Technik zumindest reduziert sind.

### Zusammenfassung der Erfindung

Die Aufgabe der Erfindung wird bereits durch ein System zur Magnetfeldkompensation nach Anspruch 1 gelöst.

Bevorzugte Ausführungsformen und Weiterbildungen der Erfindung sind dem Gegenstand der abhängigen Ansprüche, der Beschreibung sowie den Zeichnungen zu entnehmen.

Die Erfindung betrifft zum einen ein System zur Magnetfeldkompensation. Dieses umfasst eine Mehrzahl von in jeweils einer Aufnahme angeordneten Spulen sowie einen Controller, um die Spulen zur Magnetfeldkompensation anzusteuern.

Der Controller umfasst einen Sensor oder ist mit einem Sensor verbunden und steuert anhand zumindest eines Sensorsignals die Spulen hinsichtlich Polarität, Stromstärke und Frequenz derart an, dass diese ein Magnetfeld generieren, welches ein innerhalb oder außerhalb des Systems vorhandenes Störfeld zumindest teilweise kompensiert.

Gemäß der Erfindung sind die Spulen mit dem Controller verbunden und adressiert.

Der Erfindung liegt das Prinzip zugrunde, dass die einzelnen Spulen nicht lediglich mit dem Controller verbunden werden, sondern dass das System bereits Mittel zur Adressierung der Spulen vorsieht. Es liegt also eine Zuordnung vor, welche Spule über welche Verbindung mit dem Controller verbunden ist.

In einer ersten Ausführungsform der Erfindung ist die Adressierung über eine definierte Verkabelung ausgebildet. Unter einer definierten Verkabelung wird ein System verstanden, bei welchem die Kabelverbindung derart ausgebildet ist, dass die einzelnen Spulen bzw. die in den einzelnen Aufnahmen angeordneten Spulen jeweils nur über ein bestimmtes Kabel mit dem Controller verbindbar sind, wobei über das Kabel eine Adressierung der Spulen realisiert ist.

Dies kann beispielsweise über eine Codierung, insbesondere über eine mechanische Codierung, von Steckverbindungen erfolgen.

Gemäß einer weiteren Ausführungsform der Erfindung erfolgt die Adressierung über einen Bus.

Es ist insbesondere vorgesehen, dass über einen Bus eine automatische Adressierung der Spulen erfolgt. Die Aufnahmen mit den einzelnen Spulen können beispielsweise eine mechanische Adressierung über einen Schalter umfassen.

Gemäß einer bevorzugten Ausführungsform der Erfindung sind die Aufnahmen über Kabelbrücken und/oder Steckverbindungen miteinander verbunden.

So ist es möglich, die Aufnahmen als miteinander verbindbare Elemente auszugestalten, wobei jeweils nur die aneinander angrenzenden Aufnahmen miteinander verkabelt sind und ein Kabel oder eine Busverbindung zu einem Controller durchgeschleift wird.

Bei einer Weiterbildung der Erfindung ist insbesondere vorgesehen, dass die Kabelbrücken und/oder Steckverbinder an oder in einem Träger angeordnet sind, der zwei Aufnahmen miteinander verbindet.

Der Träger kann beispielsweise als Gestell ausgebildet sein, in welches die Aufnahmen eingesetzt werden.

Gemäß einer Weiterbildung der Erfindung umfassen die Aufnahmen jeweils einen lokalen Controller, welcher jeweils mit dem Controller zur Ansteuerung der Spulen zur Magnetfeldkompensation verbunden ist.

Der lokale Controller kann dabei eine Adresse, insbesondere eine konfigurierbare Adresse, umfassen.

So ist auf besonders einfache Weise auch eine automatische Adressierung möglich.

Bei einer Weiterbildung der Erfindung wird die Position der Aufnahmen jeweils vom Controller automatisch erkannt.

Eine automatische Erkennung der Position der jeweiligen Aufnahme kann zum einen über die Adressierung selbst erfolgen.

Dies ist insbesondere dann möglich, wenn die einzelnen Aufnahmen in einer definierten Reihenfolge und/oder Position zueinander aufgebaut sind. Aufgrund der Adressierung liegen in diesem Fall dem Controller bereits Informationen vor, wo die jeweilige Aufnahme eingebaut ist.

Gemäß der Erfindung wird die Positionserkennung dadurch realisiert, dass der Controller die Spulen nacheinander ansteuert und anhand von Sensorsignalen erkennt, wo die jeweilige Aufnahme eingebaut ist.

Die Erfindung betrifft des Weiteren ein System zur Magnetfeldkompensation, insbesondere ein System mit einem oder mehreren vorstehend beschriebenen Merkmalen.

Das System umfasst eine Mehrzahl von miteinander verbindbaren Wandelementen, wobei die Wandelemente jeweils zumindest eine Spule zur aktiven Magnetfeldkompensation aufweisen.

Die Erfindung sieht also ein System zur Magnetfeldkompensation vor, bei welchem die Spulen nicht in einer frei im Raum stehenden Aufnahme angeordnet sind, sondern bei welcher die Aufnahme für die Spule als Wandelement ausgebildet ist.

So kann insbesondere ein modulares System bereitgestellt werden, mit dem ein umschlossener Raum aufgebaut werden kann.

Erfindungsgemäß haben die Wandelemente dahingehend eine Doppelfunktion, als dass diese nicht nur den Raum bilden, sondern gleichzeitig Teil des aktiven Systems zur Magnetfeldkompensation sind.

Insbesondere ist vorgesehen, dass der Raum als Reinraum ausgebildet ist.

Die Wandelemente können über Kabelbrücken und/oder Steckverbinder miteinander verbunden sein, wobei eine Verbindung zu einem Controller zur Ansteuerung der Spulen in den Wandelementen ausgebildet ist.

Vorzugsweise ist dabei nur ein Wandelement unmittelbar mit dem Controller verbunden. Die Ansteuerung der weiteren Wandelemente erfolgt durch Durchschleifen des Controllersignals von Wandelement zu Wandelement.

Bei einer weiteren Ausführungsform der Erfindung kann der Controller auch in einem der Wandelemente integriert sein.

Bei einer Ausführungsform der Erfindung sind die Wandelemente mittels Trägern miteinander verbunden.

Die Wandelemente können insbesondere in die Träger eingesetzt, beispielsweise eingehängt werden.

Es ist insbesondere vorgesehen, dass die Träger zu einem Rahmen zusammengesetzt werden können, in welchen die einzelnen Wandelemente eingesetzt werden. So kann auf besonders einfache Weise ein Raum zur Aufnahme eines Gerätes ausgebildet werden.

Das System ist vorzugsweise als modulares mobil verwendbares System ausgebildet.

Eine stationäre Anbringung des Systems ist gemäß einer weiteren Ausführungsform der Erfindung aber auch möglich.

Gemäß einer Ausführungsform der Erfindung sind die Wandelemente untereinander austauschbar. So ist eine besonders einfache Montage gewährleistet.

Das erfindungsgemäße System wird insbesondere verwendet, um Geräte zur Prozessierung von Halbleiterbauelementen magnetisch aktiv zu schirmen.

### Kurzbeschreibung der Zeichnungen

Der Gegenstand der Erfindung soll im Folgenden bezugnehmend auf die Zeichnungen Fig. 1 bis Fig. 7 anhand von schematisch dargestellten Ausführungsformen näher erläutert werden.
Fig. 1 zeigt in einer perspektivischen Ansicht ein beispielhaftes System zur aktiven Magnetfeldkompensation.
Fig. 2 ist eine schematische Ansicht eines Systems zur aktiven Magnetfeldkompensation, bei welchem die Adressierung über eine definierte Verkabelung erfolgt.
Fig. 3 zeigt ein System, bei welchem die Verbindungen von Modul zu Modul durchgeschleift sind.
Fig. 4 zeigt ein System, bei dem eine Steckverbindung in den Trägern vorgesehen ist, die die Wandelemente des Systems miteinander verbinden.
Fig. 5 zeigt ein System, bei welchem die Wandelemente eine mechanische Codierung aufweisen.
Fig. 6 zeigt ein einzelnes Wandelement mit einem Schalter zur Adressierung.
Fig. 7 zeigt schematisch ein System mit einem Bus, der die Wandelemente miteinander und mit dem Controller verbindet sowie mit einer automatischen Adressierung.

### Detaillierte Beschreibung der Zeichnungen

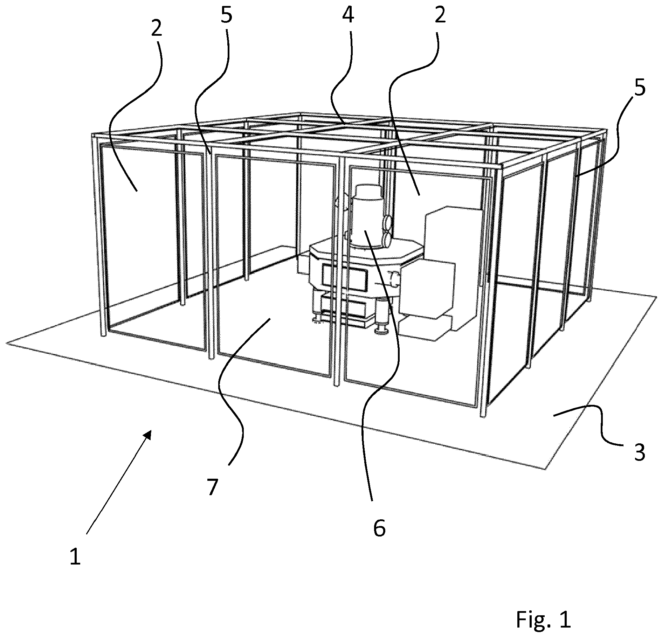

Fig. 1 zeigt in einer schematischen perspektivischen Ansicht ein System 1 zur aktiven Magnetfeldkompensation.

Das System 1 umfasst eine Mehrzahl, insbesondere eine Vielzahl, von Wandelementen 2, welche auf einem Boden 3 aufgestellt sind und so einen Raum, insbesondere einen Reinraum 7, bilden.

Die Wandelemente 2 sind dazu in miteinander verbundene Träger 5 eingesetzt. Die Träger 5 können insbesondere einen Käfig ausbilden.

In den Wandelementen 2 befindet sich jeweils eine Spule (nicht dargestellt), welche der aktiven Magnetfeldkompensation dient.

Denkbar ist auch, in der Decke 4 weitere Elemente mit Spulen vorzusehen (nicht dargestellt). Weiterhin können im Boden (nicht dargestellt) auch Spulen angeordnet sein.

In dem so gebildeten Reinraum 7 ist ein Gerät 6 zur Prozessierung von Halbleiterbauelementen angeordnet. Es handelt sich hierbei beispielsweise um ein Elektronenstrahl-Inspektionsgerät.

Die Wandelemente 2 bilden eine Raumabtrennung. Gleichzeitig dienen die Wandelemente 2 der aktiven Kompensation von magnetischen Störfeldern.

Hierzu ist ein Controller vorgesehen, der mit einem Sensor verbunden ist, welcher vorzugsweise in Nähe des Gerätes 6 zur Prozessierung von Halbleiterbauelementen angeordnet ist (in dieser Ansicht nicht dargestellt).

Die Spulen zur Magnetfeldkompensation sind so in die Wände einer Einhausung integriert.

In den folgenden Zeichnungen ist schematisch dargestellt, wie die Spulen mit dem Controller der Magnetfeldkompensation verbunden sind, wie die lokale Zuordnung und Orientierung der einzelnen Wandelemente vorzugsweise erfolgt und wie die elektrischen Verbindungen der Spulen möglichst einfach ausgebildet sind, so dass jede Spule auf einfache Weise angesteuert werden kann.

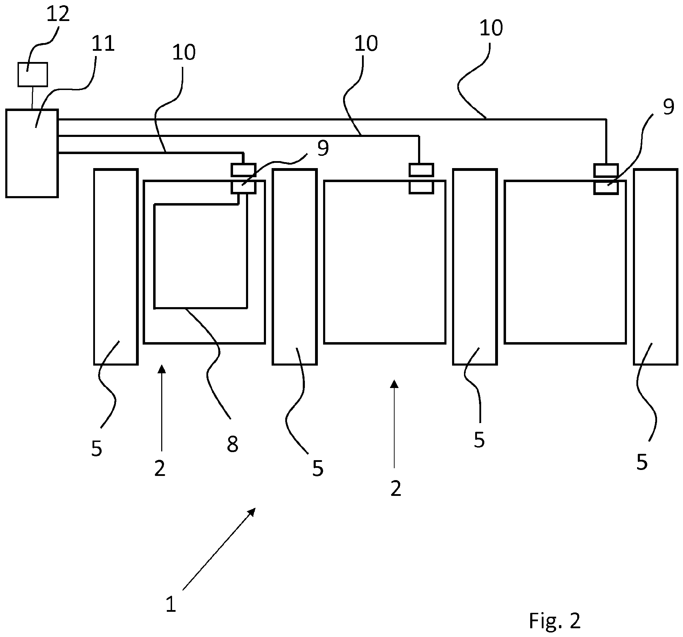

Fig. 2 zeigt schematisch dargestellt eine erste Ausführungsform der Erfindung.

Dargestellt ist eine Mehrzahl von Wandelementen 2, welche jeweils eine Spule 8 umfassen. Die einzelnen Wandelemente 2 können beispielweise ein Gehäuse aus Metall oder Kunststoff und/oder eine Bespannung, z.B. aus Folie oder Stoff, umfassen.

Die Wandelemente 2 sind jeweils zwischen einem Träger 5 eingesetzt und werden so gehalten. Zum Beispiel kann das System 1 derart ausgebildet sein, dass die Wandelemente 2 zwischen den Trägern 5 eingehängt werden können.

In diesem Ausführungsbeispiel werden die Wandelemente 2 mit einer Steckverbindung 9 jeweils über ein Kabel 10 mit dem Controller 11 verbunden.

Die Kontakte können beispielsweise Steckkontakte oder Federkontakte sein, welche beim Einsetzen des jeweiligen Wandelements 2 den Kontakt automatisch herstellen.

In diesem Ausführungsbeispiel ist jedes Wandelement über ein individuelles Kabel 10 mit dem Controller verbunden.

Die Adressierung der Wandelemente 2 bzw. der in den Wandelementen vorhandenen Spulen 8 erfolgt über eine definierte Verkabelung, insbesondere über eine Verkabelung, bei welcher die Steckverbindung 9 derart codiert ist, dass eine eindeutige Zuordnung von Wandelementen 2 zum Controller 11 vorhanden ist.

Der Controller 11 ist seinerseits mit zumindest einem Sensor 12 verbunden. Dieser kann insbesondere an dem Gerät zur Prozessierung von Halbleiterbauelementen (6 in Fig. 1) angeordnet sein.

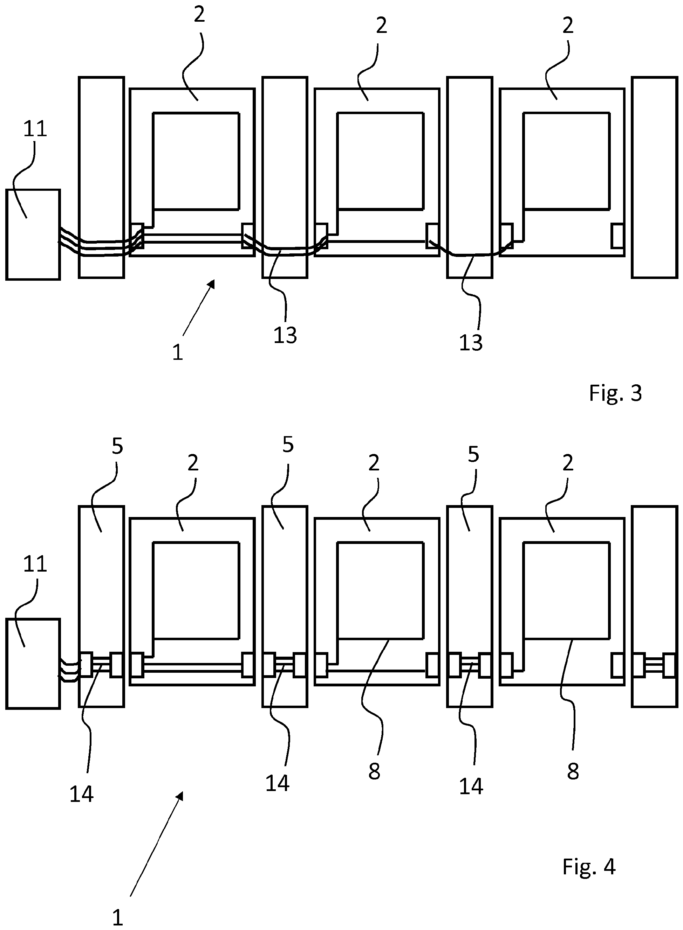

Fig. 3 zeigt eine andere Ausführungsform der Erfindung, bei welcher die Wandelemente 2 über Kabelbrücken 13 jeweils miteinander verbunden sind.

Über Kabelbrücken 13 wird so das Signal von Wandelement 2 zu Wandelement 2 durchgeschleift, bis es den Controller 11 erreicht.

Es versteht sich, dass dabei in Abhängigkeit, wie viele Wandelemente 2 hintereinander geschaltet sind, jeweils eine unterschiedliche Anzahl an Verbindungen bereitgestellt werden muss.

In der schematisch dargestellten Ausführungsform gemäß Fig. 4 ist das System 1 derart ausgebildet, dass die Wandelemente über Steckverbindungen 14 miteinander verbunden sind.

In diesem Ausführungsbeispiel umfasst jeweils der Träger 5 eine Steckverbindung 14, welche diesen mit dem angrenzenden Wandelement verbindet.

Vorzugsweise werden die Verbindungen beim Einsetzen der Wandelemente 2 zwischen die Träger 5 automatisch hergestellt.

Auch in diesem Ausführungsbeispiel wird das Signal zur Ansteuerung der Spulen 8, welches vom Controller 11 generiert wird, von Wandelement 2 zu Wandelement 2 durchgeschleift.

In einer anderen, hier nicht dargestellten Ausführungsform, bei welcher keine Träger 5 vorhanden sind, können die Wandelemente 2 auch direkt über Steckverbindungen miteinander verbunden sein. Ansonsten kann ein derartiges System entsprechend Fig. 4 ausgebildet sein.

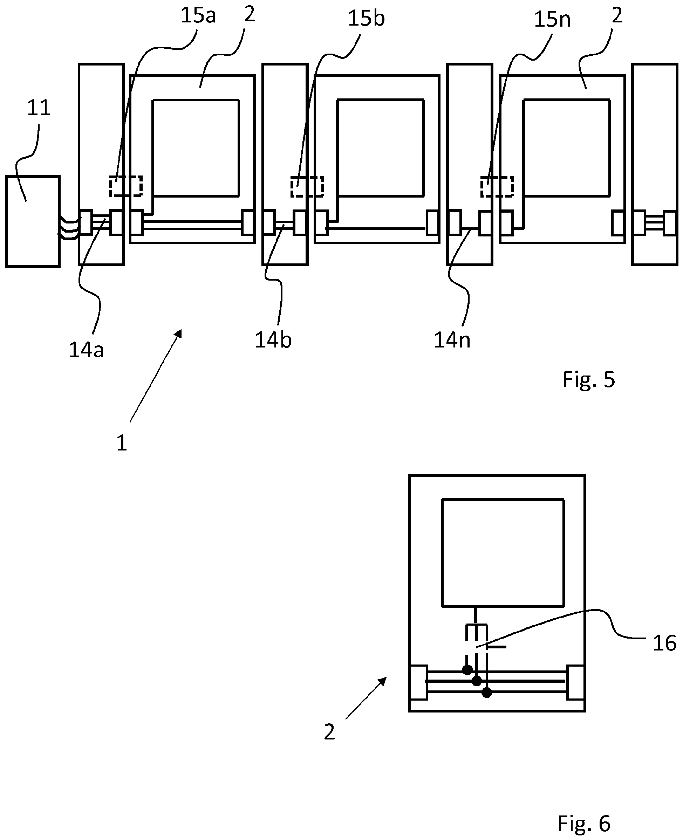

Fig. 5 zeigt eine Ausführungsform eines Systems 1 zur aktiven Magnetfeldkompensation, bei welchem jedem Wandelement 2 mindestens eine Steckverbindung 14a-14n für die Spule des Wandelements 2 zugeordnet ist.

Die Steckverbindungen 14a-14n des Trägers müssen dabei jeweils so viele Verbindungen bereitstellen, wie viele Wandelemente 2 auf der dem Controller 11 gegenüberliegenden Seite vorhanden sind.

Die Adressierung der einzelnen Wandelemente 2 kann zum einen über eine mechanische Codierung 15a-15n der Wandelemente 2 selbst bereitgestellt werden.

Dadurch kann das jeweilige Wandelement 2 nur an einer bestimmten Position eingesetzt werden. Dies erleichtert die Adressierung, zieht aber eine geringere Flexibilität bzw. Modalität nach sich.

Weiter können auch die Wandelemente beispielsweise über Schaltersteckbrücken oder ähnlichem selbst adressiert werden.

Dies ist schematisch in Fig. 6 dargestellt, die ein einzelnes Wandelement zeigt.

Über einen Schalter 16, beispielsweise einen Dip-Schalter, kann eine Adresse eingestellt werden, um das Wandelement 2 zu adressieren.

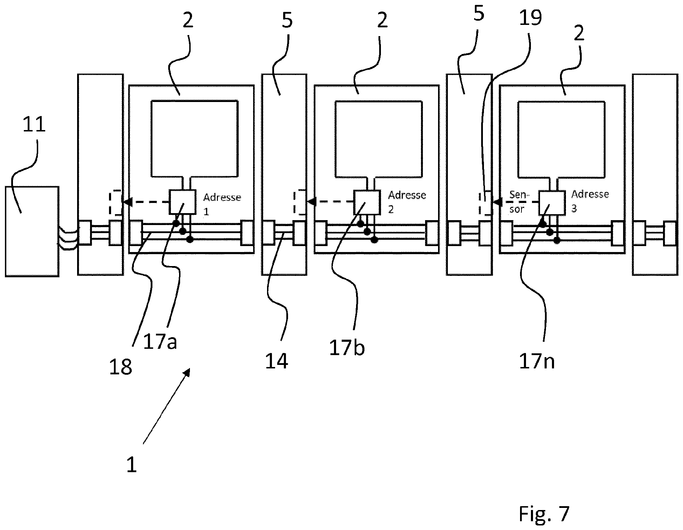

Fig. 7 zeigt eine weitere Ausführungsform der Erfindung, bei welcher vorzugsweise eine automatische Adressierung vorgesehen ist.

In diesem Ausführungsbeispiel sind die Wandelemente 2 mittels eines Bus 18 mit dem Controller 11 verbunden.

Das Bussignal wird dabei jeweils über eine Steckverbindung 14 durch die Träger 5 geschleift.

In diesem Ausführungsbeispiel hat jedes Wandelement 2 einen lokalen Controller 17a-17n. Der lokale Controller 17a-17n erzeugt aus einem Steuersignal und einer Stromversorgung den das jeweilige Wandelement 2 erforderlichen Strom in der richtigen Polarität, Stromstärke und Frequenz, um ein aktives Gegenfeld zu erzeugen.

Das Steuersignal kann beispielsweise über ein analoges Signal erzeugt werden. In diesem Fall ist für jedes Wandelement ein Steuersignal notwendig.

Weiter kann ein moduliertes Analogsignal verwendet werden. So sind mehrere Wandelemente über ein Steuersignal adressierbar.

Gemäß einer weiteren Ausführungsform der Erfindung ist ein digitales Steuersignal vorgesehen, welches über einen Bus, beispielsweise über einen Feldbus, übertragen wird. So sind eine Vielzahl von Wandelementen 2 auf einfache Weise über eine Steuerleitung adressierbar.

Zur Übertragung des Steuersignals können auch Lichtleiter verwendet werden.

Gemäß der hier dargestellten Ausführungsform ist die Anzahl der jeweils von Wandelement 2 zu Wandelement 2 durchgeschleiften Verbindungen unabhängig von der Anzahl der Wandelemente 2.

Jedem lokalen Controller 17a-17n ist eine Adresse zugeordnet, welche vorzugsweise konfiguriert werden kann.

Dies kann beispielsweise über Schalter, eine Schnittstelle, beispielsweise eine grafische Schnittstelle, einen Computer, insbesondere ausgebildet als mobiles drahtloses Handgerät etc., erfolgen.

Weiter kann eine Adressierung auch über eine am Rahmen, insbesondere am Träger 5, angeordnete Codierung 19 erfolgen.

Diese kann beispielsweise, wie hier dargestellt, über einen Sensor erfasst werden, um so die Position des Wandelements 2 zu bestimmen.

Die Codierung kann aber auch am Boden oder an der Decke angebracht sein (nicht dargestellt).

Weiter ist auch eine automatische Erkennung über eine automatisierte Adressvergabe im Netzwerk denkbar.

Die Wandelemente 2 sind vorzugsweise untereinander austauschbar.

Durch die Erfindung lassen sich sowohl temporär errichtete Räume als auch fest installierte Anlagen bereitstellen. Insbesondere lässt sich ein Reinraum aufbauen.

Der Raum kann aber auch insbesondere oben offen sein und lediglich zur optischen, akustischen oder thermischen Trennung von umgebendem Raum dienen.

Durch die Erfindung konnte ein System zur aktiven Magnetfeldkompensation bereitgestellt werden, welches sich besonders leicht aufbauen und einrichten lässt.

### Bezugszeichenliste

- 1: System zur Magnetfeldkompensation
- 2: Wandelement
- 3: Boden
- 4: Decke
- 5: Träger
- 6: Gerät zur Prozessierung von Halbleiterbauelementen
- 7: Reinraum
- 8: Spule
- 9: Steckverbindung
- 10: Kabel
- 11: Controller
- 12: Sensor
- 13: Kabelbrücke
- 14a - 14n: Steckverbindung des Trägers
- 15a - 15n: mechanische Codierung
- 16: Schalter
- 17a - 17n: lokaler Controller
- 18: Bus
- 19: Codierung

## Patentansprüche

1. System (1) zur Magnetfeldkompensation, umfassend eine Mehrzahl von in jeweils einer Aufnahme angeordneten Spulen (8), sowie einen Controller (11), um die Spulen zur Magnetfeldkompensation anzusteuern, wobei die Spulen (8) mit dem Controller (11) verbunden und adressiert sind, durch gekennzeichnet, dass System (1) als modulares System (1) ausgebildet ist, und dass die Positionserkennung dadurch realisiert wird, dass der Controller (11) die Spulen (8) nacheinander ansteuert und anhand von Sensorsignalen erkennt, wo die jeweilige Aufnahme eingebaut ist.

2. System nach dem vorstehenden Anspruch, **dadurch gekennzeichnet, dass** die Adressierung über eine definierte Verkabelung ausgebildet ist.

3. System nach Anspruch 1, **dadurch gekennzeichnet, dass** die Adressierung über einen Bus erfolgt.

4. System nach einem der vorstehenden Ansprüche, **dadurch gekennzeichnet, dass** die Aufnahmen über Kabelbrücken und/oder Steckverbindungen miteinander verbunden sind.

5. System nach dem vorstehenden Anspruch, **dadurch gekennzeichnet, dass** die Kabelbrücken und/oder Steckverbinder an oder in einem Träger angeordnet sind, der zwei Aufnahmen miteinander verbindet.

6. System nach einem der vorstehenden Ansprüche, **dadurch gekennzeichnet, dass** die Aufnahmen einen lokalen Controller umfassen, der jeweils mit dem Controller zur Ansteuerung der Spulen zur Magnetfeldkompensation verbunden ist.

7. System nach dem vorstehenden Anspruch, **dadurch gekennzeichnet, dass** lokalen Controller automatisch adressiert werden.

8. System zur Magnetfeldkompensation, nach einem der vorstehenden Ansprüche, umfassend eine Mehrzahl von miteinander verbindbaren Wandelementen, wobei die Wandelemente als Aufnahme für die Spulen ausgebildet sind.

9. System nach dem vorstehenden Anspruch, **dadurch gekennzeichnet, dass** die Wandelemente über Kabelbrücken und/oder Steckverbinder miteinander verbunden sind, wobei eine Verbindung zu einem Controller zur Ansteuerung der Spulen in den Wandelementen ausgebildet ist.

10. System nach einem der beiden vorstehenden Ansprüche, **dadurch gekennzeichnet, dass** die Wandelemente mittels Trägern miteinander verbunden sind.

11. System nach einem der drei vorstehenden Ansprüche, **dadurch gekennzeichnet, dass** die Wandelemente einen umschlossenen Raum, insbesondere einen Reinraum, bilden.

12. System nach einem der vier vorstehenden Ansprüche, **dadurch gekennzeichnet, dass** die Wandelemente untereinander austauschbar ausgebildet sind.

13. Verwendung eines Systems nach einem der vorstehenden Ansprüche zur Schirmung eines Gerätes zur Prozessierung von Halbleiterbauelementen.

## Claims

1. A system (1) for magnetic field compensation, comprising a plurality of coils (8) each one arranged in a respective receptacle, and a controller (11) for controlling the coils for magnetic field compensation, the coils (8) being connected to and addressed by the controller (11);
**characterised in that**
the system (1) is designed as a modular system (1); and that
position detection is implemented by the controller (11) sequentially driving the coils (8) and using sensor signals to identify where the respective receptacle is installed.

2. The system according to the preceding claim, **characterised in that** the addressing is implemented by predefined wiring.

3. The system according to claim 1, **characterised in that** the addressing is implemented via a bus.

4. The system according to any one of the preceding claims, **characterised in that** the receptacles are connected to one another via cable bridges and/or via plug-in connections.

5. The system according to the preceding claim, **characterised in that** the cable bridges and/or plug-in connectors are arranged on or in a support that couples two receptacles to one another.

6. The system according to any one of the preceding claims, **characterised in that** the receptacles comprise a local controller, each of which is connected to the controller for controlling the coils for magnetic field compensation.

7. The system according to the preceding claim, **characterised in that** local controllers are addressed automatically.

8. The system for magnetic field compensation according to any one of the preceding claims, comprising a plurality of wall elements that can be coupled to one another, wherein the wall elements are designed as receptacles for the coils.

9. The system according to the preceding claim, **characterised in that**
the wall elements are connected to one another via cable bridges and/or plug-in connectors, with a link to a controller for controlling the coils being implemented inside the wall elements.

10. The system according to any one of the two preceding claims, **characterised in that** the wall elements are coupled to one another via supports.

11. The system according to any one of the three preceding claims, **characterised in that** the wall elements form an enclosed space, in particular a cleanroom.

12. The system according to any one of the four preceding claims, **characterised in that** the wall elements are configured so as to be interchangeable.

13. Use of a system according to any one of the preceding claims for shielding an apparatus for processing semiconductor components.

## Revendications

1. Système (1) de compensation de champ magnétique, comportant une pluralité de bobines (8) disposées chacune dans un logement, ainsi qu'un contrôleur (11) pour commander les bobines de compensation de champ magnétique, les bobines (8) étant connectées au contrôleur (11) et adressées par celui-ci, **caractérisé par le fait que** le système (1) est conçu comme système modulaire (1), et **par le fait que** la reconnaissance de position est réalisée **par le fait que** le contrôleur (11) commande les bobines (8) les unes après les autres et reconnaît, à l'aide de signaux de capteur, l'endroit où le logement respectif est monté.

2. Système selon la revendication précédente, **caractérisé par le fait que** l'adressage est formé par un câblage défini.

3. Système selon la revendication 1, **caractérisé par le fait que** l'adressage est effectué par l'intermédiaire d'un bus.

4. Système selon l'une des revendications précédentes, **caractérisé par le fait que** les logements sont reliés entre eux par des ponts de câbles et/ou des connecteurs.

5. Système selon la revendication précédente, **caractérisé par le fait que** les ponts de câbles et/ou les connecteurs sont disposés sur ou dans un support qui relie entre eux deux logements.

6. Système selon l'une des revendications précédentes, **caractérisé par le fait que** les logements comprennent un contrôleur local qui est relié respectivement au contrôleur pour la commande des bobines pour la compensation du champ magnétique.

7. Système selon la revendication précédente, **caractérisé par le fait que** les contrôleurs locaux sont adressés automatiquement.

8. Système de compensation de champ magnétique, selon l'une des revendications précédentes, comportant une pluralité d'éléments de paroi pouvant être reliés entre eux, les éléments de paroi étant conçus comme des logements pour les bobines.

9. Système selon la revendication précédente, **caractérisé par le fait que** les éléments de paroi sont reliés entre eux par des ponts de câbles et/ou des connecteurs, une connexion à un contrôleur pour commander les bobines dans les éléments de paroi étant formée.

10. Système selon l'une des deux revendications précédentes, **caractérisé par le fait que** les éléments de paroi sont reliés entre eux à l'aide de supports.

11. Système selon l'une des trois revendications précédentes, **caractérisé par le fait que** les éléments de paroi forment un espace clos, en particulier un espace de type salle blanche.

12. Système selon l'une des quatre revendications précédentes, **caractérisé par le fait que** les éléments de paroi sont conçus pour être interchangeables entre eux.

13. Utilisation d'un système selon l'une des revendications précédentes pour le blindage d'un dispositif pour le traitement de composants semi-conducteurs.
